# EUROPEAN PATENT APPLICATION

(11) **EP 4 583 109 A1**
(43) Date of publication of application: **09.07.2025**
(21) Application number: 23935637.1
(22) Date of filing: 27.11.2023
(51) Int. Cl.: G11C 11/415

(54) **TARGET MEMORY READ-WRITE METHOD AND APPARATUS, AND DEVICE AND STORAGE MEDIUM**

(30) Priority: 10.11.2023 CN 202311498469
(71) Applicant: CRSC RESEARCH & DESIGN INSTITUTE GROUP CO., LTD., Fengtai District Beijing 100070 (CN)
(72) Inventor: HUANG, Yao, Fengtai District, Beijing 100070 (CN); JIN, Xu, Fengtai District, Beijing 100070 (CN); LIU, Jiong, Fengtai District, Beijing 100070 (CN); LIN, Ziming, Fengtai District, Beijing 100070 (CN); LIU, Guangyu, Fengtai District, Beijing 100070 (CN)
(74) Representative: Haseltine Lake Kempner LLP
(86) International application number: PCT/CN2023/134419
(87) International publication number: WO 2025/097506

(57) **Abstract**

The present discloses a read-write method, apparatus, device and storage medium for a target memory. The method includes: acquiring a first signal received by a first port and a second signal received by a second port of the target memory; acquiring a first access address corresponding to the first signal and a second access address corresponding to the second signal; determining read-write priorities respectively corresponding to the first port and the second port according to a preset rule, if the first access address and the second access address are the same; and performing a read-write operation to the target memory according to the read-write priorities respectively corresponding to the first port and the second port. With the solution of the present invention, it is possible to accurately read-write an asynchronous dual-port SRAM when two ports access the same address unit at the same time.

## Description

### CROSS-REFERENCE TO RELATED APPLICATION(S)

This application claims priority to Chinese Patent Application No. 202311498469.8, filed on November 10, 2023, the disclosure of which is incorporated herein by reference in its entirety as part of this application.

### TECHNICAL FIELD

Embodiments of the present invention relate to the technical field of integrated circuit design, and in particular, to a read-write method, apparatus, device, and storage medium for a target memory.

### BACKGROUND

Asynchronous dual-port SRAM (Static Random-Access Memory) is a special RAM (Random Access Memory) device that is widely used in high-speed data exchange in multi-CPU systems and high-speed data acquisition and processing systems. An asynchronous dual-port SRAM has two independent data exchange ports, each with a corresponding data bus, address bus, and control bus, allowing the two ports to independently and asynchronously read-write to any memory cell in the SRAM under the control of internal arbitration logic. However, when the two ports access the same address unit at the same time, an arbitration operation is required for the left and right ports. In addition, for asynchronous dual-port SRAMs, a situation may arise in which the sequence of the enable signals of the two ports cannot be judged. Therefore, there is an urgent need for an arbitration method that enables an accurate read-write operation to an asynchronous dual-port SRAM when the two ports access the same address unit at the same time.

### SUMMARY

Embodiments of the present invention provide a read-write method, apparatus, device and storage medium for a target memory to enable an accurate read-write operation to an asynchronous dual-port SRAM when two ports access the same address unit at the same time.

According to an aspect of the present invention, there is provided a read-write method for a target memory, comprising:
acquiring a first signal received by a first port and a second signal received by a second port of the target memory;
acquiring a first access address corresponding to the first signal and a second access address corresponding to the second signal;
if the first access address and the second access address are the same, determining read-write priorities respectively corresponding to the first port and the second port according to a preset rule;
performing a read-write operation to the target memory according to the read-write priorities respectively corresponding to the first port and the second port.

According to another aspect of the invention, there is provided a read-write apparatus for a target memory, the apparatus comprising:
a first acquiring module, configured to acquire a first signal received by a first port and a second signal received by a second port of the target memory;
a second acquiring module, configured to acquire a first access address corresponding to the first signal and a second access address corresponding to the second signal;
a determining module, configured to determine read-write priorities respectively corresponding to the first port and the second port according to a preset rule if the first access address and the second access address are the same;
a read-write module, configured to perform a read-write operation to the target memory according to the read-write priorities respectively corresponding to the first port and the second port.

According to another aspect of the present invention, there is provided an electronic device, comprising:
at least one processor; and
a memory communicatively connected with the at least one processor; wherein,
the memory stores a computer program executable by the at least one processor, the computer program being executed by the at least one processor to enable the at least one processor to implement the read-write method for the target memory according to any one of the embodiments of the present invention.

According to another aspect of the present invention, there is provided a computer-readable storage medium storing computer instructions for causing a processor, when executed, to implement the read-write method for the target memory according to any one of the embodiments of the present invention.

An embodiment of the present invention performs a read-write operation to a target memory according to read-write priorities respectively corresponding to a first port and a second port, by acquiring a first signal received by a first port and a second signal received by a second port of the target memory, acquiring a first access address corresponding to the first signal and a second access address corresponding to the second signal, and determining the read-write priorities respectively corresponding to the first port and the second port according to a preset rule if the first access address and the second access address are the same. With the solution of the present invention, it is possible to accurately read-write an asynchronous dual-port SRAM when the two ports access the same address unit at the same time.

It should be understood that what is described in this section is not intended to identify key or critical features of embodiments of the invention nor is it intended to limit the scope of the invention. Other features of the present invention will become apparent from the following description.

### BRIEF DESCRIPTION OF DRAWINGS

In order to more clearly illustrate the technical solutions of the embodiments of the present invention, the following will be briefly described with reference to the accompanying drawings which are required to be used in the embodiments. It is to be understood that the following drawings illustrate only certain embodiments of the present invention and are therefore not to be considered limiting in scope, and further related drawings can be derived from these drawings by those of ordinary skill in the art without the exercise of inventive labor.
FIG. 1 is a flowchart of a read-write method for a target memory in an embodiment of the present invention;
FIG. 2 is a schematic diagram of a structure of a target memory in an embodiment of the present invention;
FIG. 3 is a schematic diagram of a bit expansion in an embodiment of the present invention;
FIG. 4 is a schematic diagram of a word expansion in an embodiment of the present invention;
FIG. 5 is a schematic diagram of a word-bit simultaneous expansion in an embodiment of the present invention;
FIG. 6 is a schematic diagram of a circuit of a two-stage flip-flop buffering approach in an embodiment of the present invention;
FIG. 7 is a flowchart of a method for a two-port read-write priority determination in an embodiment of the present invention;
FIG. 8 is a waveform diagram of a read-write "zero setup time" operation in an embodiment of the present invention;
FIG. 9 is a schematic diagram of a read-write apparatus for a target memory in an embodiment of the present invention;
FIG. 10 is a schematic diagram of the structure of an electronic device implementing the read-write method for the target memory of an embodiment of the present invention.

### DETAILED DESCRIPTION

In order for those skilled in the art to better understand the solutions of the present invention, the technical solutions of the embodiments of the present invention will be clearly and completely described below in conjunction with the accompanying drawings of the embodiments of the present invention. It is obvious that the described embodiments are only embodiments of a part of the present invention, rather than all of the embodiments. Based on the embodiments in the present invention, all other embodiments acquired by those of ordinary skill in the art without making inventive labor should belong to the scope of protection of the present invention.

It is noted that the terms "first", "second" and the like in the description and claims of the present invention as well as in the drawings described above, are used for distinguishing between similar objects and not necessarily for describing a particular sequential or chronological order. It is to be understood that such use of data may be interchanged under appropriate circumstances such that the embodiments of the invention described herein are capable of being practiced in sequences other than those illustrated or described herein. Furthermore, the terms "including" and "having," and any variations thereof, are intended to cover a non-exclusive inclusion, such that, for example, a process, method, system, article, or apparatus that comprises a list of steps or elements is not necessarily limited to those steps or elements expressly listed but may include other steps or elements not expressly listed or inherent to such process, method, article, or apparatus.

### Embodiment one

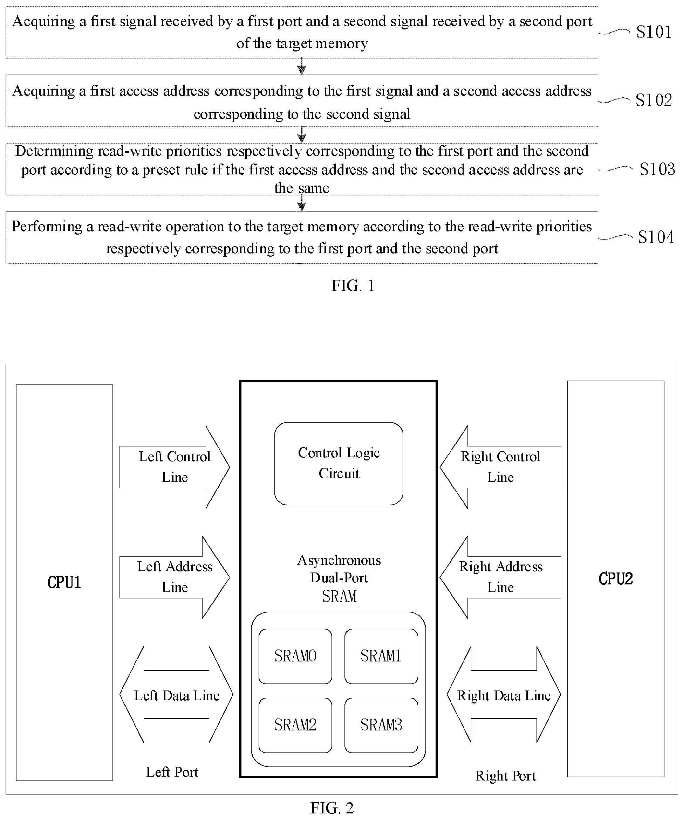

FIG. 1 is a flowchart of a read-write method for a target memory in an embodiment of the present invention. The embodiment is applicable to the case of the read-write of the target memory. The method can be performed by a read-write apparatus for a target memory in an embodiment of the present invention. The apparatus can be implemented in software and/or hardware. As shown in FIG. 1, the method specifically includes the following steps:
S101, acquiring a first signal(s) received by a first port and a second signal(s) received by a second port of the target memory.
In this embodiment, the target memory may be an asynchronous dual-port SRAM (Static Random-Access Memory).

Currently, domestic asynchronous application designs mostly employ foreign dual-port SRAM chips for data exchange. In recent years, the procurement of such chips has become more difficult, the supply cycle has been unstable, and the price has fluctuated greatly, which is not conducive to the production and maintenance of autonomous equipment. In addition, the direct asynchronous SRAM design requires starting with the process, which has a high design threshold, and expensive development cost. For the existing problem, a method for using the synchronous SRAM IP (the full name of IP is intellectual property, and it is common practice to say the IP core, which is the intellectual property core. In order to perform the function of SRAM, it is necessary to use the intellectual property core to SRAM provided by the manufacturer, and the manufacturer provides a set of encrypted intellectual property core listing information for various different specifications of SRAM IP, including area, power consumption, timing, etc.) to implement the asynchronous dual-port SRAM is proposed. The method can be applied to various asynchronous data interaction platforms. The method is extended based on existing mature IP technology, and realizes the function of asynchronous dual-port SRAM while ensuring high performance of data access, and achieves the objectives of shortening the development cycle, reducing the design threshold, reducing the development cost, realizing autonomous control of important core devices.

Since existing SRAM IPs are synchronous circuits, it is difficult to develop new purely asynchronous SRAM chips in terms of implementation difficulty, so implementing asynchronous SRAM memory arrays using factory Memory IP is a simple and efficient method.

FIG. 2 is a schematic diagram of a structure of a target memory in an embodiment of the present invention. The embodiment of the present invention uses the 8K * 8bit synchronous SRAM IP of a certain factory to implement 32K * 8bit asynchronous dual-port SRAM as an example, the overall structure of which is shown in FIG. 2. The asynchronous dual-port SRAM comprises four 8K * 8bit synchronous SRAM IPs in a total of SRAM0, SRAM1, SRAM2 and SRAM3, and further comprises a control logic circuit. The asynchronous dual-port SRAM has two independent data exchange ports. Each of the two ports has a respective data bus, address bus, and control bus (a left control line, a left address line, and a left data line for the left port, and a right control line, a right address line, and a right data line for the right port in FIG. 2). The left port is data-exchangeable with CUP1 and the right port is data-exchangeable with CUP2.

However, when the word length or capacity of a single SRAM IP module under a certain process is smaller than parameters for the SRAM memory array to be designed, expansion of the SRAM IP module is required. Embodiments of the present invention provide three methods for a bit expansion, a word expansion, or a word-bit simultaneous expansion to implement an SRAM memory array of a specific bit width and capacity.

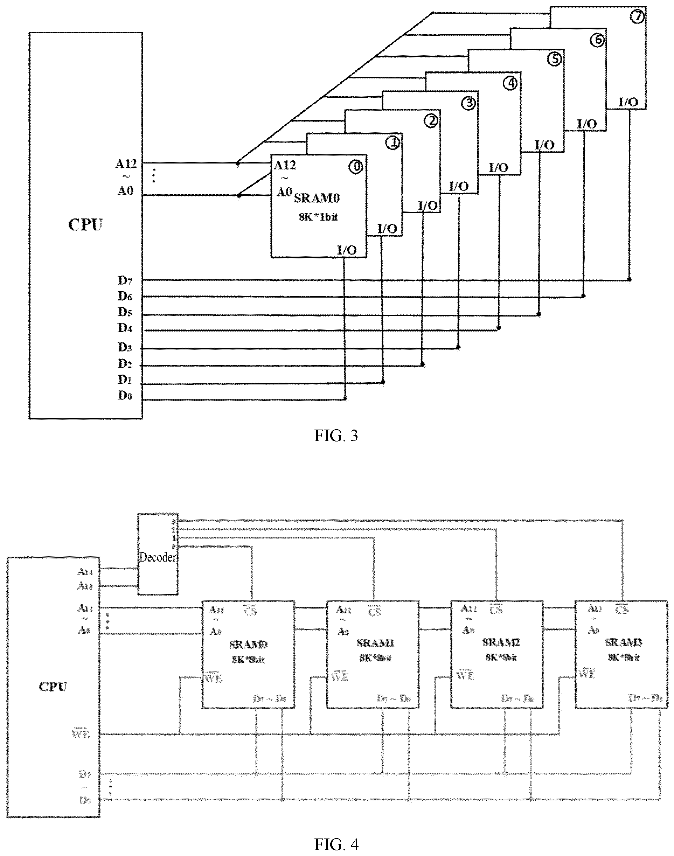

FIG. 3 is a schematic diagram of a bit expansion in an embodiment of the present invention. When the data width of the SRAM memory array to be designed is larger than the word length of a single SRAM IP module, the bit expansion mode can be adopted. That is, the address segment, the chip select terminal and the read-write control terminal of a plurality of SRAM IP modules are connected in parallel, and the data segments of the plurality of SRAM IP modules are drawn out separately. For example, 8 SRAM bits of 8K * 1 bit (1 bit can be read and written at the same time) are expanded into 8K * 8 bit (8 bits can be read and written at the same time) memory for a total capacity of 8 KB, as shown in FIG. 3. A0 ~ A12 are address segments, and the single bit I/O of each SRAM IP module ( SRAM0 ~ SRAM7 in FIG. 3) is connected to D0 ~ D7 of the CPU's data bus, respectively.

FIG. 4 is a schematic diagram of a word expansion in an embodiment of the present invention. When the SRAM memory array to be designed requires the number of words in the memory to be increased while the number of bits remains the same, the word expansion mode is adopted. That is, the address lines, the data lines and the read-write control lines are connected in parallel, and the address of the memory array is divided by connecting the chip select lines C̅S̅ to the decoder. For example, the capacity of a single SRAM in a certain process supports a generation of the maximum of 8192 rows of data at 8-bit width, i.e., 8192 * 8bit, 8kB. To achieve a 32 kB capacity, the SRAM memory array can be implemented by splicing 4 SRAM IP modules (SRAM0-SRAM3), as shown in FIG. 4, where bits A0-A12 are the lower 13-bit addresses, A13-A14 are controlled by the decoder to select which module is read (when A13A14 = 00, decoder output 0 is effective and SRAM0 is read), the single-bit I/O of each SRAM IP module (SRAM0-SRAM3) is connected to D0-D7 of the CPU's data bus, respectively, and W̅E̅ is the read-write control signal.
SRAM0 address: 00 0000 000000000-00 1111111111111,
SRAM1 address: 01 0000 000000000-01 1111111111111,
SRAM2 address: 10 0000 000000000-10 1111111111111,
SRAM3 address: 11 0000 000000000-11 111 1111111111.

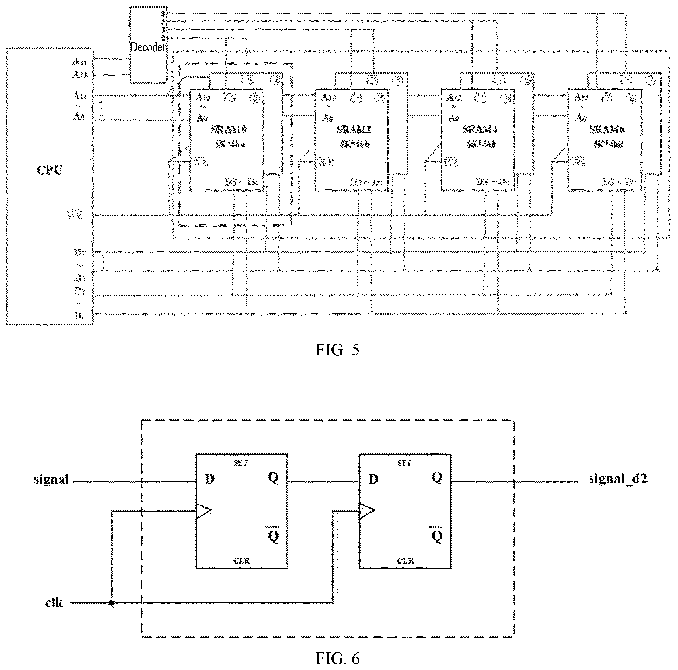

FIG. 5 is a schematic diagram of a word-bit simultaneous expansion in an embodiment of the present invention. When the word length and capacity of a single SRAM IP module are both smaller than the parameters for the SRAM memory array to be designed, a method for the word-bit simultaneous expansion is adopted, which increases both the number of stored words (word expansion) and the length of the stored word (bit expansion). For example, eight 8K * 4 bit SRAMs are used to be concatenated into a 32K * 8-bit memory by the word-bit simultaneous expansion, as shown in FIG. 5, where two 8K * 4-bit SRAMs are concatenated into an 8K * 8-bit memory by the bit expansion firstly, and then four 8K * 8-bit memory concatenated with the same manner are concatenated into a 32K * 8-bit memory array by the word expansion.

For the asynchronous SRAM memory array, whose operation is not dependent on an external clock, embodiments of the present invention are implemented using synchronous SRAM IP, which can use the OSC IP as an internal clock or an external crystal oscillator input, and can add PLL IP to multiply the clock if a high-speed clock is required. Since the signals of the chip select, the read-write control, the address, the input data, etc., which are inputted externally are asynchronous, synchronous processing is required before accessing the SRAM IP module. The synchronous processing of asynchronous signals in embodiments of the present invention may employ a multi-stage flip-flop buffering approach, i.e., a delayed beat approach. After asynchronous signals are input from the outside, buffering these signals in succession with at least two-stage flip-flops (as many times as the number of flip-flops) in the internal clock domain effectively reduces the problem of metastability due to timing failure.

FIG. 6 is a schematic diagram of a circuit of a two-stage flip-flop buffering approach in an embodiment of the present invention. As an example of a method for the two-stage flip-flop buffering, FIG. 6 shows the two-stage flip-flop, where the signal is an externally input asynchronous signal, signal _ d2 is a signal after two beats, and clk is an internal clock.

In the present embodiment, the first port may be a left port of the asynchronous dual-port SRAM, and the first signal may be an external signal received by the left port of the asynchronous dual-port SRAM. The second port may be a right port of the asynchronous dual-port SRAM, and the second signal may be an external signal received by the right port of the asynchronous dual-port SRAM. Conversely, the first port may also be the right port of the asynchronous dual-port SRAM, and the first signal may be the external signal received by the right port of the asynchronous dual-port SRAM. The second port may be the left port of the asynchronous dual-port SRAM, and the second signal may be the external signal received by the left port of the asynchronous dual-port SRAM. The present embodiment is not limited thereto, and "first", "second", and the like in the present embodiment are used to distinguish between the ports and the signals, and are not necessarily used to describe a particular sequence or succession.

Specifically, the asynchronous dual-port SRAM has two independent data exchange ports, which respectively acquire external signals received by the two ports.

S102, a first access address corresponding to the first signal and a second access address corresponding to the second signal are acquired.

The first access address may be an access address corresponding to the first signal received by the first port, i.e., an address to access the asynchronous dual-port SRAM. The second access address may be an access address corresponding to the second signal received by the second port, i.e., an address to access the asynchronous dual-port SRAM.

Specifically, the first access address corresponding to the first signal received by the first port is coupled is acquired, and the second access address corresponding to the second signal received by the second port is acquired.

S103, if the first access address and the second access address are the same, read-write priorities respectively corresponding to the first port and the second port is determined according to a preset rule.

The preset rule may be a preset rule for determining the read-write priorities corresponding to the first port and the second port, respectively. The read-write priority may be a level of which port is prioritized for the read-write operation. For example, if the read-write operation for the left port is first performed, the left port has a high priority.

Typically, an asynchronous dual-port SRAM allows two controllers to independently and asynchronously read-write access to a memory unit. When the two ports are accessed simultaneously, the following four scenarios typically occur: 1. the two ports simultaneously read-write to different address units; 2. the two ports simultaneously read the same address unit; 3. the two ports simultaneously write to the same address unit; and 4. the two ports are simultaneously access to the same address unit, one for a read operation and one for a write operation.

For the first two cases, no processing is required to achieve a proper read-write operation, but for the latter two cases, the problems of write errors and read errors may occur. Therefore, when a case where the same address unit is accessed at the same time occurs, an arbitration operation is required for the left and right ports. In addition, for the asynchronous dual-port SRAM, a case where it cannot be judged which of the two ports enable signal first may occur.

For this problem, embodiments of the present invention design "busy" logic and introduce a Flag flag signal, to ensure a fair competition between the left and right ports. The design of decision logic decides to temporarily turn off a port (i.e., the busy signal for that port is effective), the port that is not turned off is accessed normally, and the port that is turned off waits for the busy signal to be ineffective before being re-accessed.

S104, a read-write operation to the target memory is performed according to the read-write priorities corresponding to the first port and the second port respectively.

Specifically, after determining the read-write priorities corresponding to the first port and the second port respectively, an asynchronously read-write access operation to the memory cells of the asynchronous dual-port SRAM is performed respectively according to the read-write priorities respectively corresponding to the first port and the second port.

An embodiment of the present invention performs a read-write operation to a target memory according to read-write priorities respectively corresponding to a first port and a second port, by acquiring a first signal received by a first port and a second signal received by a second port of the target memory, acquiring a first access address corresponding to the first signal and a second access address corresponding to the second signal, determining read-write priorities respectively corresponding to the first port and the second port according to a preset rule if the first access address and the second access address are the same. With the solution of the present invention, it is possible to accurately read-write an asynchronous dual-port SRAM when the two ports access the same address unit at the same time.

Optionally, the first signal include a first address signal and a first enable signal, and the second signal include a second address signal and a second enable signal.

In this embodiment, the external signals received by the asynchronous dual-port SRAM may include an address signal, a data signal, and a read-write control signal. The read-write control signal W̅E̅ has a high level of read enable and a low level of write enable.

If the first access address and the second access address are the same, determining the read-write priorities respectively corresponding to the first port and the second port according to the preset rule comprises:
if the first access address and the second access address are the same, it is detected whether the first enable signal and the second enable signal are both effective.

Specifically, when the access addresses of the left and right ports are the same, it is judged whether the enable signals of both the left and right ports have been effective.

If both the first enable signal and the second enable signal are effective, first time when the first port receives the first address signal and second time when the second port receives the second address signal are acquired.

The first time may be the time when the first port receives the first address signal, the second time may be the time when the second port receives the second address signal.

Specifically, if the enable signals of the two ports have been effective when the right and left ports access the same address, the arbitration is performed by judging the sequence in which the addresses of the right and left ports are stable. It is understood that the arbitration is performed by judging the sequence in which the addresses of the right and left ports are received, and the priority of the port whose address is stable first is higher.

If the first time is earlier than the second time, the read-write priority corresponding to the first port is determined as high and the read-write priority corresponding to the second port is determined as low.

Specifically, if the first time when the first port receives the first address signal is earlier than the second time when the second port receives the second address signal, the read-write priority corresponding to the first port is determined as high, and the read-write priority corresponding to the second port is determined as low, Then, the second port is turned off (i.e., the busy signal of the second port is effective), the first port is accessed normally, and the second port waits for the busy signal to be ineffective before being re-accessed.

Optionally, after detecting whether the first enable signal and the second enable signal are both effective if the first access address and the second access address are the same, the method further comprises:
a third time when the first enable signal is received by the first port and a fourth time when the second enable signal is received by the second port are acquired if at least one of the first enable signal and the second enable signal is ineffective.

The third time may be a time when the first enable signal is received by the first port, and the fourth time may be a time when the second enable signal is received by the second port.

Specifically, if at least one of the enable signals of the two ports is ineffective when the access addresses of the left and right ports are the same, the arbitration is performed by judging the sequence in which the left and right ports are enabled. It is understood that arbitration is performed by judging the sequence in which the enable signals are received by the left and right ports, and the priority of the port whose enable signal is first effective is higher.

If the third time is earlier than the fourth time, the read-write priority corresponding to the first port is determined as high and the read-write priority corresponding to the second port is determined as low.

Specifically, if the third time when the first port receives the first enable signal is earlier than the fourth time when the second port receives the second enable signal, the read-write priority corresponding to the first port is determined as high and the read-write priority corresponding to the second port is determined as low. Then, the second port is turned off (i.e., the busy signal of the second port is effective), the first port is accessed normally, and the second port waits for the busy signal to be ineffective before being re-accessed.

Optionally, the method further comprises:
if it is detected that the first time is the same as the second time, and/or that the third time is the same as the fourth time, the read-write priorities respectively corresponding to the first port and the second port are determined according to the preset flag signal.

In this embodiment, the preset Flag signal may be a preset signal for judging the priorities of right and left ports, and the preset flag signal may be represented by a Flag.

Specifically, when the access addresses of the two ports are stable in the same clock cycle or the enable signals are enabled in the same clock cycle, the priorities of the left and right ports can be judged by the preset flag signal Flag. For example, when the Flag is 1, the right port takes priority; and when the Flag is 0, the left port takes priority. To ensure fair contention for the left and right ports, the signal is flipped after the completion of one such arbitration operation. The port prioritized after arbitration prioritizes the read-write operation, while the internal circuit enables the signal of the opposite port to be effective and internally disables access by the opposite until the operation of this port is complete.

Optionally, determining the read-write priorities respectively corresponding to the first port and the second port according to the preset flag signal comprises:
acquiring a current parameter to which the preset flag signal corresponds.

The current parameter corresponding to the preset flag signal may be the current numerical value of the preset flag signal. Exemplarily, the preset flag signal may be set to specific two numerical values, 0 and 1. When the preset flag signal takes different values, the read-write priorities corresponding to the left and right ports are also different. For example, when the Flag is 1, the right port takes priority; and when the Flag is 0, the left port takes priority.

If the current parameter is the first preset parameter, the read-write priority corresponding to the first port is determined as high, and the read-write priority corresponding to the second port is determined as low.

Exemplarily, the first preset parameter may be 0, and the first port may be a left port. When the Flag is 0, the priority of the left port is higher and the priority of the right port is lower.

If the current parameter is the second preset parameter, the read-write priority corresponding to the second port is determined as high, and the read-write priority corresponding to the first port is determined as low.

Exemplarily, the second preset parameter may be 1, and the first port may be the right port. When the Flag is 1, the priority of the right port is high and the priority of the left port is low.

Optionally, after determining the read-write priorities respectively corresponding to the first port and the second port according to the preset rule if the first access address and the second access address are the same, the method further comprises:
if the current parameter is the first preset parameter, the current parameter is flipped to the second preset parameter.

If the current parameter is the second preset parameter, the current parameter is flipped to the first preset parameter.

In the implementation, the preset flag signal is flipped one time, from 0 to 1 or from 1 to 0, every time the right and left ports are accessed at the same time and the priority cannot be judged.

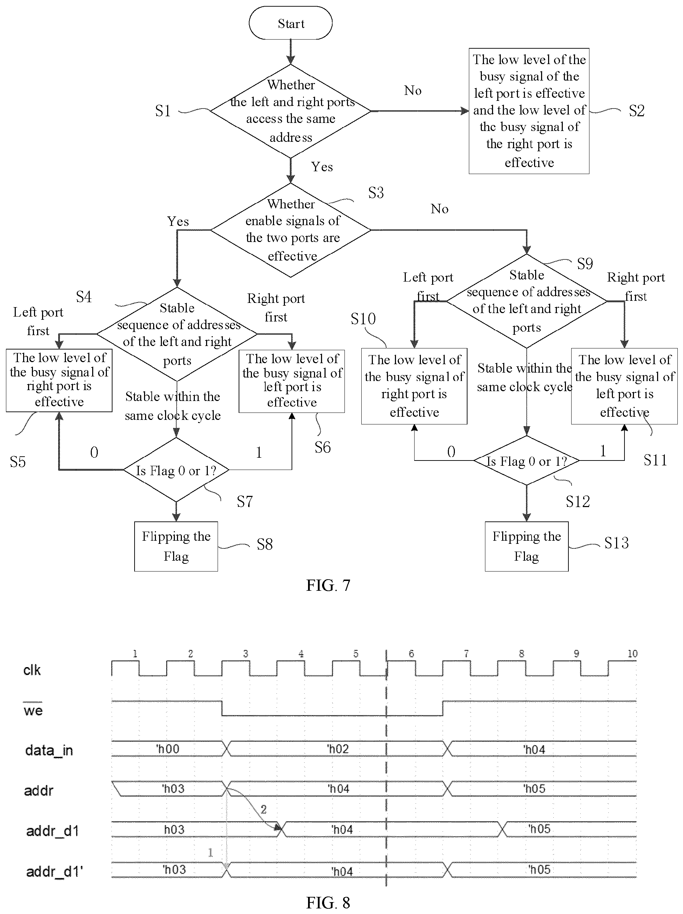

FIG. 7 is a flowchart of a method for a two-port read-write priority determination in an embodiment of the present invention. As shown in FIG. 7, the method for two-port read-write priority determination comprises the following steps:
S1. determining whether the left and right ports access the same addresses. If not, S2 is performed. If so, S3 is performed.
S2, the low level of the busy signal of the left port is effective, and the low level of the busy signal of the right port is effective.
S3. Whether enable signals of the two ports are effective is determined. If so, S4 is performed. If not, S9 is performed.
S4. A sequence in which addresses of the left and right ports are stable is determined. If the left port is first, S5 is performed. If the right port is first, S6 is performed. If they are stable within the same clock cycle, S7 is performed.
S5. The low level of the busy signal of the right port is effective.
S6. The low level of the busy signal of the left port is effective.
S7. Whether Flag is 0 or 1 is determined. If 0, S5 is performed. If 1, S6 is performed.
S8. The Flag is flipped.
S9. The sequence in which the left and right ports are enabled is determined. If the left port is first, S10 is performed. If the right port is first, S11 is performed. If they are stable within the same clock cycle, S12 is performed.
S10. The low level of the busy signal of the right port is effective.
S11. The low level of the busy signal of the left port is effective.
S12. Whether the Flag is 0 or 1 is determined. If 0, S5 is performed. If 1, S6 is performed.
S13. The Flag is flipped.

The asynchronous dual-port SRAM in the embodiment of the present invention supports the read-write "zero setup time" operation, i.e., the correct read-write operation are guaranteed when the address signals, data signals, and read-write control signals are given in alignment. In this case, without any processing of the address signals, the data signals, and the read-write control signals, the following two cases may occur (FIG. 8 is a waveform diagram of a read-write "zero setup time" operation in the embodiment of the present invention. As shown in FIG. 8, where clk is an internal clock; w̅e̅ is a read-write control signal with a high level being a read enable and a low level being a write enable; data _ in is the data to be written for the write operation; addr is an address; and addr_dl and addr_dl 'are possible waveforms after the addresses are sampled down under the internal clock).
(1) Straight arrow 1: on the 3rd clk rising edge, the internal clock takes the address value of 4 after the change. At this time, the correct write operation can be achieved if the data signal is correct.
(2) Curve arrow 2: on the 3rd clk rising edge, the internal clock takes the address value of 3 before the change. If a write operation is performed at this time, a write error occurs, i.e., the data to be written is written to the wrong address.

In view of the above problem, an embodiment of the present invention employs a solution as follows: a signal is judged to be valid if it remains stable for more than two clock cycles. For example, for the case of curve arrow 2 in FIG. 8, the addr signal is judged in a manner that if the address sampled at the third clk rising edge is the value 3 before the change, the write operation is performed after two clock cycles for which it is stable, i.e., at the sixth clk rising edge (dashed line in FIG. 8), which ensures that the address and data at this time are both stable and correct.

Optionally, performing the read-write operation to the target memory according to the read-write priorities respectively corresponding to the first port and the second port comprises:
performing the read-write operation to the target memory according to the read-write priorities corresponding to the first port and the second port, respectively, if detecting that the stabilization time of the first signal and the second signal are each greater than the preset clock cycle threshold.

The preset clock cycle threshold may be a clock cycle threshold present according to the actuality, and the embodiment of the present invention is not limited thereto. The limited, the preset clock cycle threshold may be 2 clock cycles.

**Table 1**

| clk | 1 | 2 | 3 | 4 | 5 | 6 | 7 |
|---|---|---|---|---|---|---|---|
| w̅e̅ | 1 | 1 | 0 | 0 | 0 | 0 | 1 |
| data _ in | ' h00 | ' h00 | ' h02 | ' h02 | ' h02 | ' h02 | ' h04 |
| addr | ' h03 | ' h03 | ' h04 | ' h04 | ' h04 | ' h04 | ' h05 |
| addr_dl | ' h03 | ' h03 | ' h03 | ' h04 | ' h04 | ' h04 | ' h04 |
| data _ add03 | ' h00 | ' h00 | ' h02 | ' h02 | ' h02 | ' h02 | ' h02 |
| data _ add04 | ' h00 | ' h00 | ' h00 | ' h02 | ' h02 | ' h02 | ' h02 |

**Table 2**

| clk | 1 | 2 | 3 | 4 | 5 | 6 | 7 |
|---|---|---|---|---|---|---|---|
| w̅e̅ | 1 | 1 | 0 | 0 | 0 | 0 | 1 |
| data _ in | ' h00 | ' h00 | ' h02 | ' h02 | ' h02 | ' h02 | ' h04 |
| addr | ' h03 | ' h03 | ' h04 | ' h04 | ' h04 | ' h04 | ' h05 |
| data _ dl | ' h03 | ' h03 | ' h03 | ' h04 | ' h04 | ' h04 | ' h04 |
| data _ add03 | ' h00 | ' h00 | ' h00 | ' h00 | ' h00 | ' h00 | ' h00 |
| Data _ add04 | ' h00 | ' h00 | ' h00 | ' h00 | ' h00 | ' h02 | ' h02 |

Table 1 shows the results of performing the write operation directly without any processing in the case of curved arrow 2. Table 2 shows the results of the write operation employing the method of an embodiment of the present invention. The data_addr03 and data_addr04 are the data corresponding to addresses 3 and 4 in SRAM, respectively. It can be seen that in the case of Table 1, the write operation wrongly writes data 2 to address 3. After processing, in Table 2, after address 4 is held stable for two clock cycles, the write operation is performed, and data 2 is correctly written to address 4.

Technical solution in accordance with an embodiment of the present invention, an SRAM memory array of a specific bit width and capacity is implemented through multiple SRAM IP modules by the word expansion, the bit expansion, or the word-bit simultaneous expansion. The asynchronous signal is input into the synchronous SRAM IP module after being synchronously processed using a multi-stage flip-flop buffering approach, achieving asynchronous access to the dual-port SRAM. Using "busy" logic to arbitrate for simultaneous access to the same address by the left and right ports, and introducing a Flag signal to guarantee fair contention of the left and right ports carries out a correct read-write operation of the dual-port SRAM. The address signals, the data signals, and the control signals are judged and processed to carry out a read-write "zero setup time" operation. Through the technical solution of the present invention, the extension based on existing mature IP technology realizes the function of asynchronous dual-port SRAM while ensuring high performance of data access, and realizes the objectives of shortening the development cycle, reducing the design threshold, reducing the development cost, realizing autonomous control of important core devices. At the same time, the operation of reading and writing the asynchronous dual-port SRAM can be accurately performed when two ports access the same address unit simultaneously.

### Embodiment two

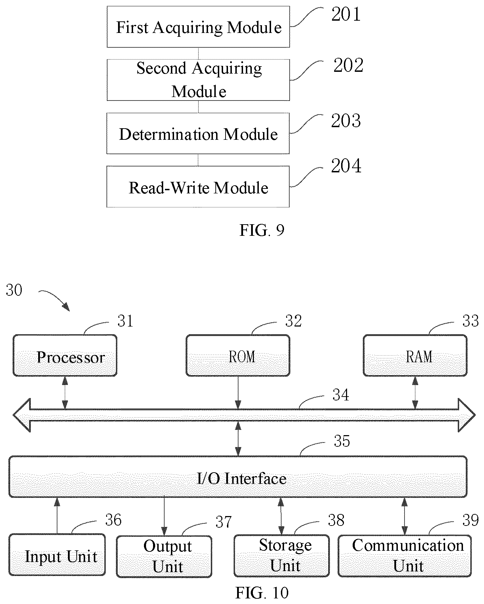

FIG. 9 is a schematic diagram of a read-write apparatus for a target memory in an embodiment of the present invention. The present embodiment may be applicable to the case of reading and writing the target memory. The apparatus may be implemented in the manner of software and/or hardware, and the apparatus may be integrated in any device providing the function of reading and writing target memory. As shown in FIG. 9, the read-write apparatus for the target memory specifically comprises: a first acquiring module 201, a second acquiring module 202, a determining module 203 and a read-write module 204.

The first acquiring module 201, is configured to acquire a first signal received by a first port and a second signal received by a second port of the target memory.

The second acquiring module 202, is configured to acquire a first access address corresponding to the first signal and a second access address corresponding to the second signal.

The determining module 203, is configured to determine read-write priorities corresponding to the first port and the second port respectively according to a preset rule if the first access address and the second access address are the same.

The read-write module 204, is configured to perform a read-write operation to the target memory according to the read-write priorities respectively corresponding to the first port and the second port.

Optionally, the first signal include a first address signal and a first enable signal and the second signal include a second address signal and a second enable signal.

The determining module 203 comprises:
a detection unit configured to detect whether the first enable signal and the second enable signal are both effective if the first access address and the second access address are the same;
a first acquiring unit configured to acquire a first time when the first port receives the first address signal and a second time when the second port receives the second address signal, if the first enable signal and the second enable signal are both effective; and
a first determining unit configured to determine the read-write priority corresponding to the first port as high and the read-write priority corresponding to the second port as low if the first time is earlier than the second time.

Optionally, the apparatus further comprises:
a second acquiring unit configured to acquire a third time when the first enable signal is received by the first port and a fourth time when the second enable signal is received by the second port, if at least one of the first enable signal and the second enable signal is ineffective; and
a second determining unit configured to determine the read-write priority corresponding to the first port as high and the read-write priority corresponding to the second port as low if the third time is earlier than the fourth time.

Optionally, the apparatus further comprises:
a third determining unit configured to determine the read-write priorities corresponding to the first port and the second port respectively, according to a preset flag signal, if it is detected that the first time and the second time are the same, and/or that the third time and the fourth time are the same.

Optionally, the third determining unit is specifically configured to:
acquire a current parameter to which the preset flag signal corresponds;
if the current parameter is a first preset parameter, determine the read-write priority corresponding to the first port as high, and determine the read-write priority corresponding to the second port as low; and
if the current parameter is a second preset parameter, determine the read-write priority corresponding to the second port as high, and determine the read-write priority corresponding to the first port as low.

Optionally, the apparatus further comprises:
a first flipping module, configured to flip the current parameter to the second preset parameter if the current parameter is the first preset parameter; and
a second flipping module, configured to flip the current parameter to the first preset parameter if the current parameter is the second preset parameter.

Optionally, the read-write module comprises:
a reading unit, configured to perform the read-write operation to the target memory according to the read-write priorities corresponding to the first port and the second port, respectively, if detecting that the stabilization time of the first signal and the second signal are each greater than a preset clock cycle threshold.

The above product can perform the read-write method for the target memory provided by any of the embodiments of the present invention, and has functional modules and advantageous effects corresponding to those of the read-write method for the target memory.

### Embodiment Three

FIG. 10 shows a schematic diagram of a structure of an electronic device 30 that may be used to implement an embodiment of the present invention. The electronic devices are intended to represent various forms of digital computers, such as laptops, desktops, workstations, personal digital assistants, servers, blade servers, mainframes, and other appropriate computers. The electronic device may also represent various forms of mobile devices, such as personal digital processing, cellular telephones, smart phones, wearable devices (e.g., helmets, glasses, watches, etc.), and other similar computing devices. The components shown herein, their connections and relationships, and their functions, are by way of example only, and are not meant to limit implementations of the inventions described and/or claimed in this document.

As shown in FIG. 10, the electronic device 30 comprises at least one processor 31, and a memory, such as a read-only memory (ROM) 32, and a random access memory (RAM) 33, etc., communicatively connected with the at least one processor 31. The memory stores a computer program executable by the at least one processor. The processor 31 may perform various appropriate actions and processes in accordance with a computer program stored in a read-only memory (ROM) 32 or loaded into a random access memory (RAM) 33 from a storage unit 38. Various programs and data required for the operation of the electronic device 30 may also be stored in the RAM 33. The processor 31, the ROM 32 and the RAM 33 are connected to each other by a bus 34. An input/output (I/O) interface 35 is also connected to the bus 34.

A number of components in the electronic device 30 are connected to the I/O interface 35, including: an input unit 36, such as a keyboard, a mouse, and the like; an output unit 37 such as various types of displays, speakers, and the like; a storage unit 38, e.g., magnetic disk, optical disk, and the like; and a communications unit 39, such as a network card, a modem, a wireless communications transceiver, and the like. The communication unit 39 allows the electronic device 30 to exchange information/data with other devices over a computer network such as the Internet and/or various telecommunication networks.

The processor 31 may be various general-purpose and/or special-purpose processing components with processing and computing capabilities. Some examples of the processor 31 include, but are not limited to, a central processing unit (CPU), a graphics processing unit (GPU), various specialized artificial intelligence (AI) computing chips, various processors running machine learning model algorithms, a digital signal processor (DSP), and any suitable processor, controller, microcontroller, or the like. The processor 31 performs the various methods and processes described above, such as the read-write method for the target memory, comprising:
acquiring a first signal received by a first port and a second signal received by a second port of the target memory;
acquiring a first access address corresponding to the first signal and a second access address corresponding to the second signal;
if the first access address and the second access address are the same, determining read-write priorities respectively corresponding to the first port and the second port according to a preset rule;
performing a read-write operation to the target memory according to the read-write priorities respectively corresponding to the first port and the second port.

In some embodiments, the read-write method for the target memory may be implemented as a computer program tangibly embodied on a computer-readable storage medium, such as storage unit 38. In some embodiments, part or all of the computer program may be loaded into and/or installed onto the electronic device 30 via the ROM 32 and/or the communication unit 39. When the computer program is loaded into the RAM 33 and executed by the processor 31, one or more steps of the read-write method for the target memory described hereinabove may be performed. Alternatively, in other embodiments, the processor 31 may be configured in any other suitable way (e.g. by means of firmware) to perform the read-write method for the target memory.

Various implementations of the systems and techniques described above can be realized in the digital electronic circuitry, the integrated circuitry, the field programmable gate arrays (FPGA), the application specific integrated circuits (ASIC), the application specific standard products (ASSP), the system-on-a-chip systems (SOC), the load programmable logic devices (CPLD), the computer hardware, the firmware, the software, and/or combinations thereof. These various implementations can include the implementation in one or more computer programs that are executable and/or interpretable on a programmable system including at least one programmable processor, that may be special or general purpose, and that may receive/transmit data and instructions from/to, a storage system, at least one input device, and at least one output device.

Computer programs for carrying out methods of the present invention may be written in any combination of one or more programming languages. These computer programs may be provided to a processor of a general purpose computer, a special purpose computer, or other programmable data processing apparatus, such that the computer programs, when executed by the processor, cause the functions/operations specified in the flowcharts and/or schematic diagrams to be implemented. The computer program may execute entirely on the machine, partly on the machine, partly on the machine and partly on a remote machine as stand-alone software packages or entirely on the remote machine or server.

In the context of the present invention, a computer readable storage medium may be a tangible medium that can contain, or store a computer program for use by or in connection with an instruction execution system, apparatus, or device. A computer readable storage medium may include, but is not limited to, an electronic, magnetic, optical, electromagnetic, infrared, or semiconductor system, apparatus, or device, or any suitable combination of the foregoing. Alternatively, the computer readable storage medium may be a machine readable signal medium. More specific examples of the machine readable storage medium would include an electrical connection based on one or more wires, a portable computer diskette, a hard disk, a random access memory (RAM), a read-only memory (ROM), an erasable programmable read-only memory (EPROM or Flash memory), an optical fiber, a convenient compact disc read-only memory (CD-ROM), an optical storage device, a magnetic storage device, or any suitable combination of the foregoing.

To provide for interaction with a user, the systems and techniques described here can be implemented on an electronic device having a display apparatus (e.g., a CRT (cathode ray tube) or LCD (liquid crystal display) monitor) for displaying information to the user; and a keyboard and a pointing device (e.g., a mouse or a trackball) by which a user may provide input to an electronic device. Other kinds of devices can be used to provide for interaction with a user as well. For example, the feedback provided to the user can be any form of sensory feedback (e.g., a visual feedback, an auditory feedback, or a tactile feedback); and input from the user can be received in any form (including acoustic, speech, or tactile input).

The systems and techniques described here may be implemented in a computing system that includes a back-end component (e.g., as a data server), or that includes a middleware component (e.g., an application server), or that includes a front-end component (e.g., a user computer having a graphical user interface or a Web browser through which a user can interact with an implementation of the systems and techniques described here), or a computing system that includes any combination of such back end, middleware, or front end components. The components of the system can be interconnected by any form or medium of digital data communication (e.g., a communication network). Examples of communication networks include a local area network (LAN), a wide area network (WAN), block-chain networks, and in Internet.

The computing system can include clients and servers. The clients and servers are generally remote from each other and typically interact through a communication network. The relationship of client and server arises by virtue of computer programs running on the respective computers and having a client-server relationship to each other. The server may be a cloud server, also referred to as a cloud computing server or a cloud host, and is a host product in a cloud computing service architecture to address the drawbacks of the traditional physical host and VPS services that are difficult to manage and have weak business scalability.

It should be understood that various forms of the flow shown above may be used, with steps reordered, added, or deleted. For example, each step described in the present invention may be executed in parallel, may be executed sequentially, or may be executed in a different order, which is not limited herein as long as the desired result of the technical solution of the present invention can be achieved.

The above detailed description is not to be construed as limiting the scope of the present invention. It should be apparent to those skilled in the art that various modifications, combinations, sub-combinations, and substitutions may occur depending on design requirements and other factors. It is intended that all such modifications, equivalents, and improvements be included within the spirit and scope of the invention.

## Claims

1. A read-write method for a target memory, **characterized in** comprising:
acquiring a first signal received by a first port and a second signal received by a second port of the target memory;
acquiring a first access address corresponding to the first signal and a second access address corresponding to the second signal;
determining read-write priorities respectively corresponding to the first port and the second port according to a preset rule, if the first access address and the second access address are the same; and
performing a read-write operation to the target memory according to the read-write priorities respectively corresponding to the first port and the second port.

2. The method of claim 1, **characterized in that** the first signal comprises a first address signal and a first enable signal, and the second signal comprises a second address signal and a second enable signal;
wherein if the first access address and the second access address are the same, determining read-write priorities corresponding respectively to the first port and the second port according to the preset rule comprises:
detecting whether both the first enable signal and the second enable signal are effective if the first access address and the second access address are the same;
acquiring a first time when the first port receives the first address signal and a second time when the second port receives the second address signal, if both the first enable signal and the second enable signal are effective; and
determining the read-write priority corresponding to the first port as high and determining the read-write priority corresponding to the second port as low, if the first time is earlier than the second time.

3. The method of claim 2, **characterized in** further comprising, after detecting whether both the first enable signal and the second enable signal are both effective if the first access address and the second access address are the same:
acquiring a third time when the first port receives the first enable signal and a fourth time when the second port receives the second enable signal, if at least one of the first enable signal and the second enable signal is ineffective; and
determining the read-write priority corresponding to the first port as high and determining the read-write priority corresponding to the second port as low, if the third time is earlier than the fourth time.

4. The method of claim 3, **characterized in** further comprising:
determining the read-write priorities respectively corresponding to the first port and the second port according to a preset flag signal, if it is detected that the first time and the second time are the same and/or that the third time and the fourth time are the same.

5. The method of claim 4, **characterized in that** determining the read-write priorities respectively corresponding to the first port and the second port according to the preset flag signal comprises:
acquiring a current parameter to which the preset flag signal corresponds;
determining the read-write priority corresponding to the first port as high, and determining the read-write priority corresponding to the second port as low, if the current parameter is a first preset parameter; and
determining the read-write priority corresponding to the second port as high, and determining the read-write priority corresponding to the first port as low, if the current parameter is a second preset parameter.

6. The method according to claim 5, **characterized in** further comprising, after determining read-write priorities respectively corresponding to the first port and the second port according to the preset rule if the first access address and the second access address are the same:
flipping the current parameter to the second preset parameter, if the current parameter is the first preset parameter; and
flipping the current parameter to the first preset parameter, if the current parameter is the second preset parameter.

7. The method of claim 1, **characterized in that** performing the read-write operation to the target memory according to the read-write priorities respectively corresponding to the first port and the second port comprises:
performing the read-write operation to the target memory according to the read-write priorities respectively corresponding to the first port and the second port, if detecting that stabilization time of the first signal and the second signal are each greater than a preset clock cycle threshold.

8. A read-write apparatus for a target memory, **characterized in** comprising:
a first acquiring module, configured to acquire a first signal received by a first port and a second signal received by a second port of the target memory;
a second acquiring module, configured to acquire a first access address corresponding to the first signal and a second access address corresponding to the second signal;
a determining module, configured to determine read-write priorities respectively corresponding to the first port and the second port according to a preset rule if the first access address and the second access address are the same; and
a read-write module, configured to perform a read-write operation to the target memory according to the read-write priorities respectively corresponding to the first port and the second port.

9. An electronic device, **characterized in** comprising:
at least one processor; and
a memory communicatively connected with the at least one processor; wherein,
the memory stores a computer program executable by the at least one processor, the computer program being executed by the at least one processor to enable the at least one processor to implement the read-write method for the target memory of any one of claims 1-7.

10. A computer-readable storage medium having stored thereon computer instructions for causing a processor, when executed, to implement the read-write method for the target memory of any one of claims 1-7.
